# EUROPEAN PATENT APPLICATION

(11) **EP 4 484 842 A1**
(43) Date of publication of application: **01.01.2025**
(21) Application number: 23902153.8
(22) Date of filing: 21.08.2023
(51) Int. Cl.: F24F 11/89, F24F 11/88, F24F 1/0007, H05K 7/20

(54) **ELECTRIC CONTROL BOX, AIR-CONDITIONER INDOOR UNIT AND AIR CONDITIONER**

(30) Priority: 12.12.2022 CN 202223357199 U
(71) Applicant: GD Midea Heating & Ventilating Equipment Co., Ltd., Foshan, Guangdong 528311 (CN); Hefei Midea Heating & Ventilating Equipment Co., Ltd., Hefei, Anhui 230601 (CN)
(72) Inventor: GE, Shanshan, Foshan, Guangdong 528311 (CN); GU, Yong, Foshan, Guangdong 528311 (CN); LI, Yunzhi, Foshan, Guangdong 528311 (CN); KAN, Changli, Foshan, Guangdong 528311 (CN); TANG, Changqing, Foshan, Guangdong 528311 (CN); ZHOU, Baisong, Foshan, Guangdong 528311 (CN); ZHU, Menghao, Foshan, Guangdong 528311 (CN); MA, Mingtao, Foshan, Guangdong 528311 (CN); WEN, Lichao, Foshan, Guangdong 528311 (CN); WU, Lin, Foshan, Guangdong 528311 (CN); FENG, Zhengbo, Foshan, Guangdong 528311 (CN); YAO, Xiao, Foshan, Guangdong 528311 (CN); SHI, Danmei, Foshan, Guangdong 528311 (CN)
(74) Representative: RGTH
(86) International application number: PCT/CN2023/114013
(87) International publication number: WO 2024/124944

(57) **Abstract**

An electric control box is provided. The electric control box includes a box body, a circuit board, and a heat sink. The box body has a chamber, and an air inlet and an air outlet that are in communication with the chamber. The chamber has an air duct, and the air inlet and the air outlet are in communication with each other via the air duct. The box body is configured to allow air to be introduced into the air duct from the air inlet and to flow out of the air outlet. The circuit board is disposed in the chamber. The heat sink is disposed at the circuit board and located in the air duct.

## Description

### CROSS-REFERENCE TO RELATED APPLICATION

The present application claims priority to Chinese Patent Application No. 202223357199.2, titled "ELECTRIC CONTROL BOX, AIR-CONDITIONER INDOOR UNIT, AND AIR CONDITIONER", and filed with China National Intellectual Property Administration on December 12, 2022, the entire disclosure of which is incorporated herein by reference.

### FIELD

The present disclosure relates to the field of air conditioning technologies, and more particularly, to an electric control box, an air-conditioner indoor unit, and an air conditioner.

### BACKGROUND

An air-conditioner indoor unit is provided with an electric control box to ensure normal operation of the air-conditioner indoor unit. The electric control box generally comprises a circuit board. The circuit board generates heat during operation, the heat is easily accumulated and affects the normal operation of the circuit board since a space enclosed by the electric control box is relatively sealed.

### SUMMARY

The present disclosure aims to solve the technical problem in the related art at least to some extent. To this end, the present disclosure proposes an electric control box.

To achieve the above-mentioned object, the present disclosure relates to an electric control box. The electric control box comprises a box body, a circuit board, and a heat sink. The box body has a chamber, and an air inlet and an air outlet that are in communication with the chamber. The chamber has an air duct, and the air inlet and the air outlet are in communication with each other via the air duct. The box body allows air to be introduced into the air duct from the air inlet and to flow out of the air outlet. The circuit board is disposed in the chamber. The heat sink is disposed at the circuit board.

In some embodiments of the present disclosure, the air duct has an air inflowing end and an air outflowing end that are offset from each other.

In some embodiments of the present disclosure, the air duct comprises a first flow section, a second flow section, and a third flow section that are in communication with one another. The second flow section is located between the first flow section and the third flow section. The heat sink is disposed at the second flow section. An extending direction of the first flow section and an extending direction of the third flow section intersects respectively with an extending direction of the second flow section. The air inflowing end is disposed at the first flow section. The air outflowing end is disposed at the third flow section.

In some embodiments of the present disclosure, the electric control box further comprises an air duct housing defining the air duct. The air duct housing has an end connected to the air inlet and another end connected to the air outlet.

In some embodiments of the present disclosure, the heat sink comprises a heat dissipation base and a plurality of heat dissipation fins arranged at the heat dissipation base. The heat dissipation base is disposed on the circuit board. An airflow channel is formed between adjacent heat dissipation fins of the plurality of heat dissipation fins.

In some embodiments of the present disclosure, the adjacent heat dissipation fins are parallel to each other.

The present disclosure also relates to an air-conditioner indoor unit. The air-conditioner indoor unit comprises a wind wheel and the above-mentioned electric control box. The air is introduced into the chamber from the air inlet and flows out of the air outlet by an action of the wind wheel.

In some embodiments of the present disclosure, the wind wheel is a centrifugal wind wheel, and the electric control box is located in an axial direction of an inlet of the wind wheel.

In some embodiments of the present disclosure, the electric control box comprises an inner side plate facing towards the inlet of the wind wheel and an outer side plate. The air outlet is formed at the inner side plate. The air inlet is formed at the outer side plate and in communication with an ambient environment.

The present disclosure also relates to an air conditioner. The air conditioner comprises the above-mentioned air-conditioner indoor unit.

### BRIEF DESCRIPTION OF THE DRAWINGS

In order to clearly explain technical solutions in embodiments of the present disclosure or in the related art, drawings needed to be used in description of the embodiments or the related art are briefly described below. Obviously, the drawings as described below merely illustrate some embodiments of the present disclosure. Based on structures shown in these drawings, other designs can be obtained by those skilled in the art without making creative effort.
FIG. 1 is a partial schematic view of an air-conditioner indoor unit according to some embodiments.
FIG. 2 is an exploded view of an electric control box according to some embodiments.
FIG. 3 is a schematic view of an air duct housing according to some embodiments.
FIG. 4 is a schematic view of an air duct housing according to some embodiments.
FIG. 5 is a schematic view of an air duct housing according to some embodiments.
FIG. 6 is a schematic view of a heat sink according to some embodiments.

### Description of reference numbers:

electric control box 1000;
box body 1100, chamber 1110, outer side plate 1120, air inlet 1121, inner side plate 1130, and air outlet 1131;
circuit board 1200;
heat sink 1300, heat dissipation base 1310, heat dissipation fin 1320, and airflow channel 1330;
air duct housing 1400, air duct 1410, air inflowing end 1411, air outflowing end 1412, first flow section 1413, second flow section 1414, and third flow section 1415; and
wind wheel 2000, and inlet 2100.
Realization of the objects, functional features, and advantages of the present disclosure will be further described with reference to the embodiments and the drawings.

### DETAILED DESCRIPTION OF THE EMBODIMENTS

Technical solutions of embodiments of the present disclosure will be described clearly and completely below with reference to the accompanying drawings of the embodiments of the present disclosure. Obviously, the embodiments described below are only a part of the embodiments of the present disclosure, rather than all embodiments of the present disclosure. On a basis of the embodiments of the present disclosure, all other embodiments obtained by those skilled in the art without making creative effort shall fall within the protection scope of the present disclosure.

It should be noted that all directional indications (such as up, down, left, right, front, back...) in the embodiments of the present disclosure are only used to explain a relative positional relationship, a motion situation, etc., between components in a specific posture (as shown in the drawings), and the directional indication will also change correspondingly if the specific posture changes.

In the present disclosure, unless clearly specified or limited otherwise, the technical terms "connected", "fixed", etc., are understood broadly, such as a fixed connection or a detachable connection or connection as one piece; mechanical connection or electrical connection; direct connection or indirect connection through an intermediate; internal communication of two components or interaction relations between two components. For those skilled in the art, the specific meaning of the above-mentioned terms in the present disclosure can be understood according to specific circumstances.

In addition, descriptions related to terms "first" and "second", etc. in the present disclosure are only used for descriptive purposes, and cannot be understood as indicating or implying relative importance or implicitly indicating the number of indicated technical features. Therefore, features associated with "first" and "second" may explicitly or implicitly include at least one of the features. In addition, the technical solutions in the various embodiments may be combined with each other, but must be feasible to those of ordinary skill in the art. When the combination of technical solutions leads to inconsistencies or becomes unfeasible, such combination shall be deemed nonexistent and, therefore, not within the protection scope claimed in the present disclosure.

The present disclosure proposes an electric control box, which will be described in conjunction with an air-conditioner indoor unit below. It is understandable that the electric control box related in the present disclosure is not limited to being applied in the air-conditioner indoor unit, but may also be applied in other products with the electric control box.

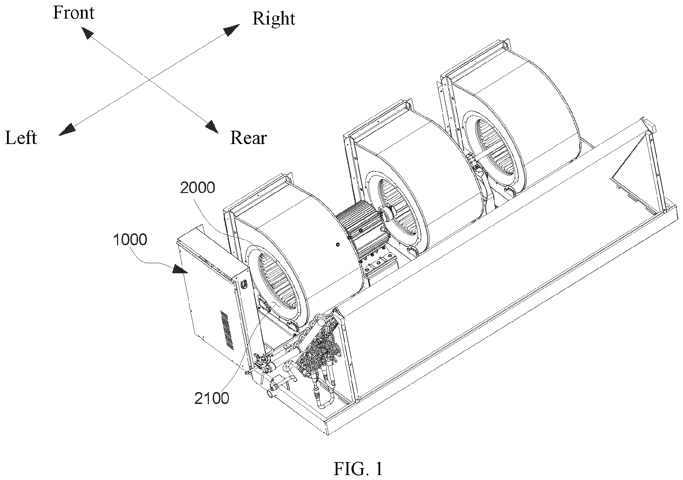

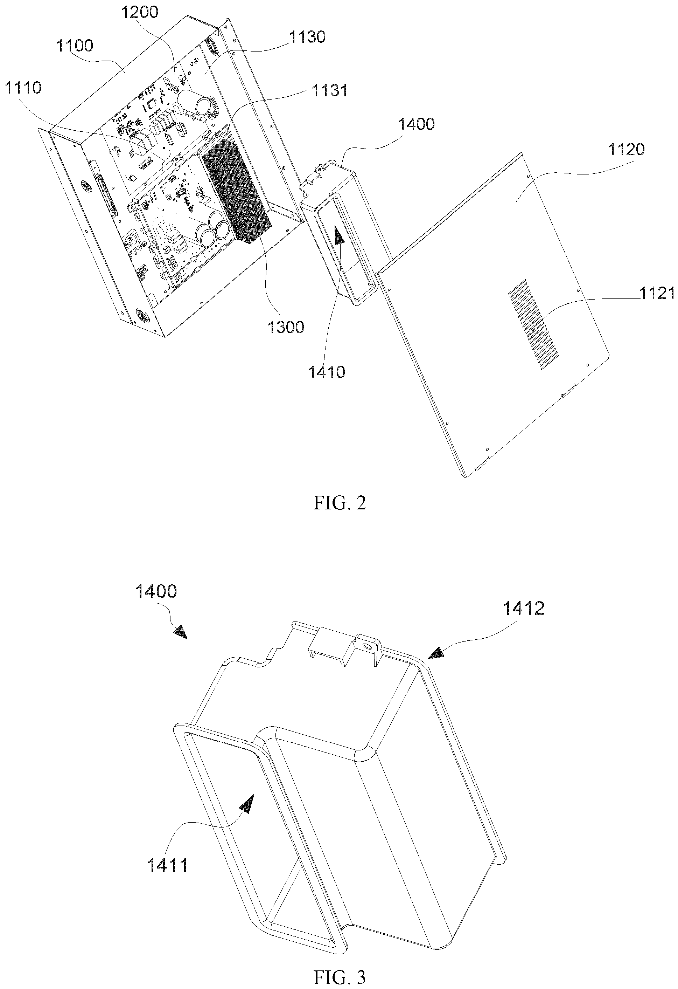

With reference to FIGS. 1 and 2, in some embodiments of the present disclosure, the electric control box 1000 includes a box body 1100, a circuit board 1200, and a heat sink 1300. Through cooperation among the box body 1100, the circuit board 1200, and the heat sink 1300, heat generated by the circuit board 1200 can be taken away. Thus, the circuit board 1200 is prevented from overheating.

Generally speaking, the air-conditioner indoor unit has an evaporator, a motor, a wind wheel 2000, etc. The motor is drivingly connected to the wind wheel 2000, to drive the wind wheel 2000 to rotate. The wind wheel 2000 rotates to form a negative pressure for sucking indoor air. For example, the wind wheel 2000 is located in front of the evaporator. The negative pressure is formed when the motor is configured to control the wind wheel 2000 to rotate. The indoor air is introduced into the air-conditioner indoor unit from rear to front, flows through the evaporator and the wind wheel 2000 in sequence, and then is output forwards into an indoor environment. The air, when flowing through the evaporator, exchanges heat with the evaporator. It is understandable that the air-conditioner indoor unit needs to be connected to the air-conditioner outdoor unit to ensure a circulation of a refrigerant. The air, when flowing through the evaporator, exchanges heat with the refrigerant inside the evaporator to cool down the indoor air. In order to ensure the normal operation of the air-conditioner indoor unit, it is necessary that the air-conditioner indoor unit is provided with an electric control box 1000. The electric control box 1000 is electrically connected to other components of the air-conditioner indoor unit, and may also be electrically connected to the air-conditioner outdoor unit. The electric control box 1000 is an indispensable part for normal operation of an air conditioning system.

The electric control box 1000 includes the box body 1100 and the circuit board 1200. A chamber 1110 is formed inside the box body 1100, and the circuit board 1200 may be mounted in the chamber 1110. That is, the box body 1100 serves to support and accommodate the circuit board 1200, preventing damage of water and dust from an ambient environment (such as an indoor space) to the circuit board 1200. For example, the box body 1100 has a cubic structure as a whole. The box body 1100 is mounted at a bottom of the air-conditioner indoor unit and may be hided in a housing of the air-conditioner indoor unit. The box body 1100 is arranged vertically as a whole, and the circuit board 1200, when disposed in the chamber 1110, is also arranged vertically. Therefore, a horizontal space occupied by the air-conditioner indoor unit is reduced. It is understandable that the circuit board 1200 is a circuit board 1200 provided with a variety of electronic components. In this way, the circuit board 1200 heats up during operation and generates a large amount of heat. An accumulation of heat that cannot be dissipated in time has an adverse effect on the normal operation of the circuit board 1200, in which aging of the electronic components of the circuit board 1200 is accelerated, and even worse, the air-conditioner indoor unit is directly out of operation.

To this end, in this embodiment, the box body 1100 has an air inlet 1121 and an air outlet 1131. The air inlet 1121 is in communication with the chamber 1110, and the air outlet 1131 is also in communication with the chamber 1110. Air may flow into the chamber 1110 from the air inlet 1121 and to flow out of the air outlet 1131. In this process, a disturbance of the air is formed in the chamber 1110 with the flow of the air, and the heat generated by the circuit board 1200 can be taken away, to prevent the heat from accumulating in the chamber 1110. It is understandable that there are many solutions for the box body 1100 to be configured to allow air to be introduced from the air inlet 1121 and to flow out of the air outlet 1131. For example, a power source is provided in the box body 1100, and during operation of the power source, the air is drawn into the chamber 1110 from the air inlet 1121 and discharged from the air outlet 1131. Alternatively, no power source is provided in the box body 1100, but an external power source is used to enable the air to flow through the chamber 1110. Regardless of the method used, just ensure that the air flows through the chamber 1110 and thus takes away the heat.

In another exemplary embodiment of the present disclosure, in order to further enhance the heat dissipation effect, the electric control box 1000 further includes the heat sink 1300. The heat sink 1300 is disposed at the circuit board 1200. Therefore, the heat generated by the circuit board 1200 is easily transferred to the heat sink 1300. That is, a heat dissipation area is increased by providing the heat sink 1300. Moreover, since the heat sink 1300 is also disposed in the chamber 1110, the air, when flowing through the chamber 1110, can take away heat of the heat sink 1300. In this way, efficient heat dissipation is achieved.

From the above, in the technical solution of this embodiment, by providing the air inlet 1121 and the air outlet 1131 at the box body 1100, and providing the heat sink 1300 at the circuit board 1200, the heat generated by the circuit board 1200 during operation is easily transferred to the heat sink 1300. As the air flows from the air inlet 1121 to the chamber 1110 and flows out of the air outlet 1131, the air flows and can take away the heat of the heat sink 1300 since the circuit board 1200 and the heat sink 1300 each are disposed in the chamber 1110. Thus, the circuit board 1200 is cooled down. As a result, the circuit board 1200 is kept within a suitable temperature range, to avoid the circuit board 1200 from overheating and affecting its normal operation.

As illustrated in FIG. 2, in some embodiments of the present disclosure, in order to facilitate the flow of the air, an air duct 1410 is provided at the box body 1100. The air duct 1410 is located in the chamber 1110, and the air duct 1410 has an air inflowing end 1411 in communication with the air inlet 1121 and an air outflowing end 1412 in communication with the air outlet 1131. When the air is introduced from the air inlet 1121, that is, the air is introduced into the air duct 1410 through the air inflowing end 1411 of the air duct 1410, and subsequently is discharged from the air outlet 1131 through the air outflowing end 1412 of the air duct 1410, the heat can be taken away with the flow of the air since the heat sink 1300 is disposed in the air duct 1410.

Providing the air duct 1410 serves to guide the flow of the air, which accelerates efficiency of the air flow. As a result, the heat can be taken away quickly, to accelerate the heat dissipation. It is understandable that the air duct 1410 is disposed in the chamber 1110, which may be that the chamber 1110 is partially occupied by the air duct 1410, or may be considered that the entire chamber 1110 is composed of the air duct 1410 and a space outside the air duct 1410. Since the air, when introduced into the chamber 1110, may carry some foreign matters, such as dust, the air transmission can be isolated by providing the air duct 1410. Since the heat sink 1300 is disposed at the circuit board 1200, providing the air duct 1410 cannot significantly affect the transfer of the heat to the heat sink 1300, and can also prevent an adverse effect caused by a direct action of the air on other parts of the circuit board 1200. For example, the circuit board 1200 is provided with corresponding electronic components at other parts of the circuit board 1200, and airflow is isolated from these electronic components by providing the air duct 1410. As such, dust accumulation due to a direct action of the air on these electronic components can be prevented.

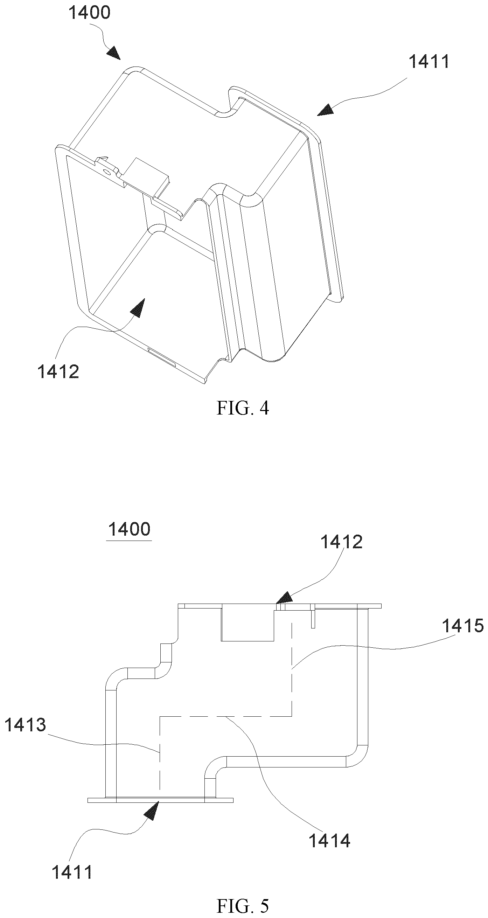

With reference to FIG. 5, in some embodiments of the present disclosure, the air outflowing end 1412 and the air inflowing end 1411 of the air duct 1410 are offset from each other. As such, an air flowing path can be extended to enhance the heat dissipation effect.

In an exemplary embodiment of the present disclosure, the air needs to be in full contact with the heat sink 1300 to take away the heat of the heat sink 1300 as much as possible. Meanwhile, the air, relative to the box body 1100, needs to flow through the box body 1100. If the air flows through the box body 1100 in a thickness direction of the box body 1100 (a left-right direction shown in FIG. 1), in order to ensure the full contact between the air and the heat sink 1300, it is necessary to design a box body 1100 having a larger thickness, so that a heat sink 1300 with a larger dimension can be accommodated and the contact between the heat sink 1300 and the air can be enhanced. However, such a design will cause a larger horizontal space occupied by the box body 1100, which will cause a larger horizontal dimension of the air-conditioner indoor unit. Therefore, with the air outflowing end 1412 and the air inflowing end 1411 offset from each other, the air outflowing end 1412 and the air inflowing end 1411 are not collinear in the thickness direction of the box body 1100. The offset arrangement thus extends a distance between the air outflowing end 1412 and the air inflowing end 1411 of the air duct 1410, i.e., extends an air transmission path. The heat sink 1300 can occupy this space as much as possible, and the contact between the heat sink 1300 and the air is therefore enhanced. In this way, the heat dissipation effect is improved while avoiding an excessive thickness of the box body 1100. The above is only an example in the thickness direction. In other embodiments of the present disclosure, the air outflowing end 1412 and the air inflowing end 1411 may also offset from each other in other directions to achieve similar technical effects, which will not be repeated herein.

In another exemplary embodiment of the present disclosure, as illustrated in FIG. 5, the air duct 1410 has a third flow section 1415, a second flow section 1414, and a first flow section 1413 that are in communication with each other. The air inflowing end 1411 of the air duct 1410 is formed at the first flow section 1413. The air outflowing end 1412 of the air duct 1410 is formed at the third flow section 1415. The heat sink 1300 is disposed at the second flow section 1414. The air is introduced from the first flow section 1413 and flows to the second flow section 1414, and then flows out of the third flow section 1415 to take away the heat from the heat sink 1300. An extending direction of the first flow section 1413 and an extending direction of the third flow section 1415 intersect with an extending direction of the second flow section 1414. As such, the air outflowing end 1412 and the air inflowing end 1411 of the air duct 1410 may be offset from each other. For example, the extending direction of each of the first flow section 1413 and the third flow section 1415 is perpendicular to the extending direction of the second flow section 1414, and the extending direction of the first flow section 1413 and the extending direction of the third flow section 1415 are parallel to each other and non-collinear. As such, the box body 1100 may be designed as a flat cube, and the vertically arranged box body 1100 can reduce the horizontal space occupied by the box body 1100. The extending direction of the first flow section 1413 and the extending direction of the third flow section 1415 is the thickness direction of the box body 1100, and the extending direction of the third flow section 1415 is a length direction or a height direction of the box body 1100. The space occupied by the box body 1100 is optimized through the cooperation among the third flow section 1415, the second flow section 1414, and the first flow section 1413.

As illustrated in FIGS. 2 to 4, in some embodiments of the present disclosure, an air duct housing 1400 is provided in order to facilitate the formation of the air duct 1410 in the chamber 1110. For example, the air duct housing 1400 may be made into a separate component, for example, prepared through injection molding as one piece. The air duct housing 1400, during the mounting of the air duct housing 1400, is placed in the chamber 1110 as a whole. The air duct housing 1400 has an end connected to a wall of the box body 1100 to allow for docking with the air inlet 1121. As such, the air may be introduced into the air duct 1410 when input from the air inlet 1121. The air duct housing 1400 has another end connected to another wall of the box body 1100 to allow for docking with the air outlet 1131. As such, the air may be discharged through the air outlet 1131 when flowing out of the air duct 1410.

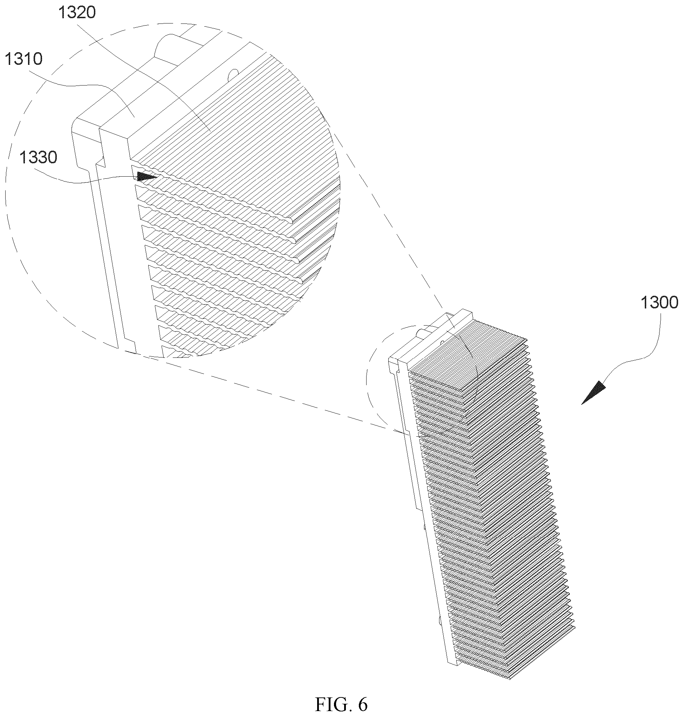

As illustrated in FIG. 6, in some embodiments of the present disclosure, the heat sink 1300 includes a heat dissipation fin 1320 and a heat dissipation base 1310. The heat dissipation base 1310 is a base configured to fix the heat dissipation fin 1320. The heat dissipation base 1310 is disposed on the circuit board 1200, which serves to support the heat dissipation fin 1320 and is combined with the heat dissipation fin 1320 as a whole. The heat dissipation base 1310 is fixed to the circuit board 1200, and the heat from the circuit board 1200 is easily transferred to the heat dissipation base 1310 and then to the heat dissipation fin 1320. A plurality of heat dissipation fins 1320 is provided and arranged at predetermined intervals, and the "plurality of" refers to at least two. As such, a predetermined space is formed between adjacent heat dissipation fins 1320 of the plurality of heat dissipation fins 1320, and this space is an airflow channel 1330. Therefore, a plurality of airflow channels 1330 is formed by providing the plurality of heat dissipation fins 1320. Thus, a heat dissipation contact area between the heat dissipation fin 1320 and the air is increased. When the heat is transferred to the heat dissipation fin 1320, the air flows through the airflow channel 1330 and thus can take away the heat easily. In this way, rapid heat dissipation is achieved.

In another exemplary embodiment of the present disclosure, in order to speed up the flow of the air to allow the air to take away the heat in time and reduce resistance to the air, with reference to FIG. 6, in some embodiments of the present disclosure, the adjacent heat dissipation fins 1320 of the plurality of adjacent heat dissipation fins 1320 are parallel to each other. As such, when the air flows through the airflow channel 1330 formed between the two adjacent heat dissipation fins 1320, the resistance to the air is minimal to avoid slowing down the flow of the air. As a result, the air flows through the airflow channel 1330 as quickly as possible, and thus the heat can be taken away rapidly.

The present disclosure also relates to an air-conditioner indoor unit. The air-conditioner indoor unit includes a wind wheel 2000 and the electric control box 1000 according to the above-mentioned embodiments. A structure of the electric control box 1000 of this embodiment refers to the above-mentioned embodiments. Since the air-conditioner indoor unit adopts the technical solutions of the above-mentioned embodiments, the air-conditioner indoor unit at least has the beneficial effects brought by the technical solutions of the above-mentioned embodiments, and details thereof will not be repeated herein.

In an exemplary embodiment of the present disclosure, the wind wheel 2000 needs to be connected to a motor of the air-conditioner indoor unit in a driven manner. The wind wheel 2000 rotates by an action of the motor to form a negative pressure inside the air-conditioner indoor unit, and the air from the ambient environment (such as the indoor space) is thus drawn into the air-conditioner indoor unit, and then re-outputted to the indoor environment through the wind wheel 2000. It is precisely because the negative pressure is formed during the operation of the wind wheel 2000, the air may be introduced into the chamber 1110 from the air inlet 1121 by an action of a pressure difference, and flow out of the air outlet 1131. In this way, there is no need to provide a power source in the chamber 1110. The wind wheel 2000 amounts to formation of a power source to drive the air to flow through the chamber 1110.

As illustrated in FIG. 1, in some embodiments of the present disclosure, there are many types of wind wheels 2000, such as a centrifugal wind wheel, a crossflow wind wheel, and an axial flow wind wheel. The centrifugal wind wheel is used in this embodiment, and the electric control box 1000 is located in an axial direction of the wind wheel 2000 (a left-right direction in FIG. 1). As such, the wind wheel 2000 can face towards the electric control box 1000 for sucking the air. Therefore, a speed of the air flowing through the chamber 1110 is accelerated.

In an exemplary embodiment of the present disclosure, the wind wheel 2000 rotates about a rotation axis by driving of the motor, and the rotation axis is in the axial direction of the wind wheel 2000. When the wind wheel 2000 rotates, the air is introduced from an inlet 2100 of the wind wheel 2000. That is, a strong drawing force can be formed at a position opposite to the inlet 2100 of the wind wheel 2000 to draw the air into the wind wheel 2000. The electric control box 1000 is located in the axial direction of the wind wheel 2000 and is aligned with the inlet 2100 of the wind wheel 2000. Air in the ambient environment (the indoor space), by the action of the wind wheel 2000, can be easily introduced into the chamber 1110 from the air inlet 1121 and be discharged from the air outlet 1131 until the air is drawn into the wind wheel 2000. In this way, the flow of the air is effectively accelerated, and heat exchange efficiency is ensured.

For example, as illustrated in FIG. 2, the electric control box 1000 includes an outer side plate 1120 and an inner side plate 1130. The chamber 1110 is formed between the outer side plate 1120 and the inner side plate 1130. The inner side plate 1130 faces towards the inlet 2100 of the wind wheel 2000, and the aforementioned air outlet 1131 is formed at inner side plate 1130. The outer side plate 1120 is away from the inlet 2100 of the wind wheel 2000, closer to the indoor space, or exposed to the indoor space, and the aforementioned air inlet 1121 is formed at the outer side plate 1120 and in communication with the ambient environment (the indoor space). The present disclosure also relates to an air conditioner. The air conditioner includes the above-mentioned air-conditioner indoor unit. In an exemplary embodiment of the present disclosure, the air-conditioner outdoor unit is connected to the air-conditioner indoor unit to realize a circulation of a refrigerant. A structure of the air-conditioner indoor unit of this embodiment refers to the above-mentioned embodiments. Since the air conditioner adopts the technical solutions of the above-mentioned embodiments, the air conditioner at least has the beneficial effects brought by the technical solutions of the above-mentioned embodiments, and details thereof will not be repeated herein.

The above are only some embodiments of the present disclosure, and do not limit the patent scope of the present disclosure. Under the concept of the present disclosure, equivalent structural transformations made by using the contents of the description and the drawings of the present disclosure, or directly/indirectly applied in other related arts are included in the patent protection scope of the present disclosure.

## Claims

1. An electric control box, comprising:
a box body having a chamber, and an air inlet and an air outlet that are in communication with the chamber, wherein the chamber has an air duct, the air inlet and the air outlet being in communication with each other via the air duct, and wherein the box body allows air to be introduced into the air duct from the air inlet and to flow out of the air outlet;
a circuit board disposed in the chamber; and
a heat sink disposed at the circuit board and located in the air duct.

2. The electric control box according to claim 1, wherein the air duct has an air inflowing end and an air outflowing end that are offset from each other.

3. The electric control box according to claim 2, wherein the air duct comprises a first flow section, a second flow section, and a third flow section that are in communication with one another, the second flow section being located between the first flow section and the third flow section, the heat sink being disposed at the second flow section, an extending direction of the first flow section and an extending direction of the third flow section intersecting respectively with an extending direction of the second flow section, the air inflowing end being disposed at the first flow section, and the air outflowing end being disposed at the third flow section.

4. The electric control box according to claim 1, further comprising an air duct housing defining the air duct, wherein the air duct housing has an end connected to the air inlet and another end connected to the air outlet.

5. The electric control box according to claim 1, wherein the heat sink comprises:
a heat dissipation base disposed on the circuit board; and
a plurality of heat dissipation fins arranged at the heat dissipation base, an airflow channel being formed between adjacent heat dissipation fins of the plurality of heat dissipation fins.

6. The electric control box according to claim 5, wherein the adjacent heat dissipation fins are parallel to each other.

7. An air-conditioner indoor unit, comprising:
a wind wheel; and
an electric control box according to any one of claims 1 to 6, air being introduced into a chamber from an air inlet and flowing out of an air outlet by an action of the wind wheel.

8. The air-conditioner indoor unit according to claim 7, wherein:
the wind wheel is a centrifugal wind wheel; and
the electric control box is located in an axial direction of an inlet of the wind wheel.

9. The air-conditioner indoor unit according to claim 8, wherein:
the electric control box comprises an inner side plate facing towards the inlet of the wind wheel and an outer side plate;
the air outlet is formed at the inner side plate; and
the air inlet is formed at the outer side plate and in communication with an ambient environment.

10. An air conditioner, comprising an air-conditioner indoor unit according to any one of claims 7 to 9.
